# EUROPEAN PATENT APPLICATION

(11) **EP 2 391 195 A2**
(43) Date of publication of application: **30.11.2011**
(21) Application number: 11004359.3
(22) Date of filing: 26.05.2011
(51) Int. Cl.: H05K 7/14, G06F 1/18

(54) **High-density computer sytem with high-performance CPU card sharing structure**

(30) Priority: 31.05.2010 CN 201099210324
(71) Applicant: Caswell Inc., 23845 New Taipei City (TW)
(72) Inventor: Yang, Chih-wei, 22159 New Taipei City (TW); Li, Shin-Jau, 23554 New Taipei City (TW); Huang, Shih-Hua, 23146 New Taipei City (TW)
(74) Representative: Zeitler - Volpert - Kandlbinder

(57) **Abstract**

A high-density computer system with a high-performance CPU card sharing structure comprises: a chassis 10, having a main backplane 13, and a main control circuit 13A and main backplane slots 131 on the main backplane 13; at least one expansion card module 20 in the chassis 10 and having a sub-backplane 21 with a sub-control circuit and second sub-backplane slots 24, and a first sub-backplane slot 25 at an end of the sub-backplane 21 and corresponding to the main backplane slots 131, and the first sub-backplane slot 25, sub-control circuit and second sub-backplane slots 24 being electrically coupled; CPU cards 30, including a CPU card 30 inserted into the second sub-backplane slot 24, and the CPU card 30 having a CPU 31; and at least one high-performance CPU card 30B, 30C, 30D, having two or more CPUs 31, and the high-performance CPU cards 30B, 30C, 30D being inserted into positions of two or more of the second sub-backplane slots 24. The computer system provides a powerful modular assembling function to enhance the economic benefits and product competitiveness.

## Description

### BACKGROUND OF THE INVENTION

### 1. Field of the Invention:

The present invention relates to a computer system, and more particularly to a high-density computer system with a high-performance CPU card sharing structure capable of replacing, upgrading, and selecting different required modules and having excellent expandability and economic benefits.

### 2. Brief Description of the Related Art:

Present industrial computers generally adopt a blade server with a main architecture comprising: a chassis, and a main backplane and a plurality of containing spaces in the chassis, a plurality of slots formed on the main backplane and disposed opposite to the plurality of containing spaces respectively, and a plurality of CPU cards installed in the plurality of containing spaces of the chassis respectively, and inserted and fixed into the slots of the main backplane to complete an electric connection. Although the design of the conventional blade server can meet the requirements of the industrial computer system, yet its applications still have many drawbacks. For example, the CPU card includes a central processing unit (CPU) installed thereon, but the quantity of containing spaces of the chassis is fixed, such that the upper limit of the total number of CPUs is also fixed. In the condition of having a small number of CPUs, the real-time multitasking function cannot be achieved. If it is necessary to enhance the computing function of the blade server, then the whole CPU card is replaced or upgraded, and cannot be adjusted quickly according to customer requirements. As a result, a higher cost is incurred and incompliance to economic benefits of the customers, and such arrangement is obviously not a good design. In addition, if a customer needs to add other functions or related modules such as storage, wireless, encryption/decryption, 3D image and other computer and Internet applications or modules, there will be a limitation to the module structure, and thus the whole CPU card must be replaced, and the modules cannot be changed or upgraded flexibly and conveniently. Obviously, the conventional blade server requires breakthroughs and improvements. Therefore, it is an important subject for related manufacturers and designers to overcome the drawbacks of the conventional blade server.

In view of the aforementioned drawbacks and deficiencies of the applications of the conventional blade server, the inventor of the present invention based on years of experience in the related industry to conduct extensive researches and experiments, and finally developed a high-density computer system with the real-time multitasking functions that can be upgraded conveniently or modularized flexibly to overcome the drawbacks of the prior art.

### SUMMARY OF THE INVENTION

Therefore, it is a primary objective of the present invention to provide a high-density computer system with a high-performance CPU card sharing structure and powerful modular assembling function, swappability and replaceability to provide advantages on manufacturing, assembling and flexible expansion applications, so as to enhance the economic benefits and product competitiveness.

Another objective of the present invention is to provide a high-density computer system with a high-performance CPU card sharing structure capable of improving the containing space of the chassis to increase the number of installed CPUs, so as to achieve the real-time multitasking computing function, provide a convenient computation and a quick upgrade, and comply with the economic benefits and user requirements.

Another objective of the present invention is to provide a high-density computer system with a high-performance CPU card sharing structure that allows a selection of different modules such as wireless modules, storage modules and related modules of other computer and Internet applications according to customer requirements, and provides a flexible replacement and allocation in a sharing architecture.

Another objective of the present invention is to provide a high-density computer system with a high-performance CPU card sharing structure, wherein the CPU card can be an independent computing system or a plurality of main CPU cards allocated for executing an integrated computing system, or a main CPU card with different performances selected according to customer requirement to provide flexible replacement or allocation by the sharing architecture.

To achieve the aforementioned objectives, the present invention provides a technical measure, comprising: a chassis, having a plurality of containing spaces, a main backplane installed in the chassis, and a main control circuit and a plurality of main backplane slots installed and formed on the main backplane respectively; at least one expansion card module, inserted into the containing space, and including a sub-backplane, a sub-control circuit and a plurality of second sub-backplane slots inserted and formed on the sub-backplane respectively, and a first sub-backplane slot formed at an end of the sub-backplane and corresponding to the main backplane slot; a plurality of CPU cards, installed onto the expansion card module, and inserted and coupled to the second sub-backplane slots respectively, and a CPU being installed on each CPU card; and at least one high-performance CPU card, having two or more CPUs, and each high-performance CPU card being inserted and coupled to two or more positions of the second sub-backplane slots.

The technical contents of the present invention will become apparent by the detailed description of the preferred embodiments together with the illustration of related drawings as follows:

### BRIEF DESCRIPTION OF THE INVENTION

Fig. 1 is a perspective view of the present invention;
Fig. 2 is an exploded view of the present invention;
Figs. 3A~3G are schematic views of various high-performance CPU cards of the present invention;
Fig. 4 is a schematic view of a system architecture of the present invention; and
Fig. 5 is a schematic view of controlling a main control circuit of the present invention.

### DETAILED DESCRIPTION OF THE PREFERRED EMBODIMENTS

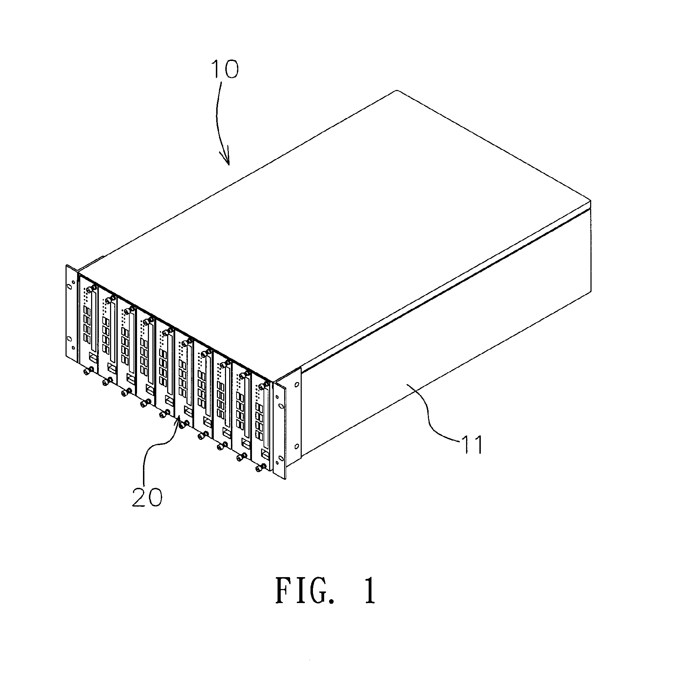

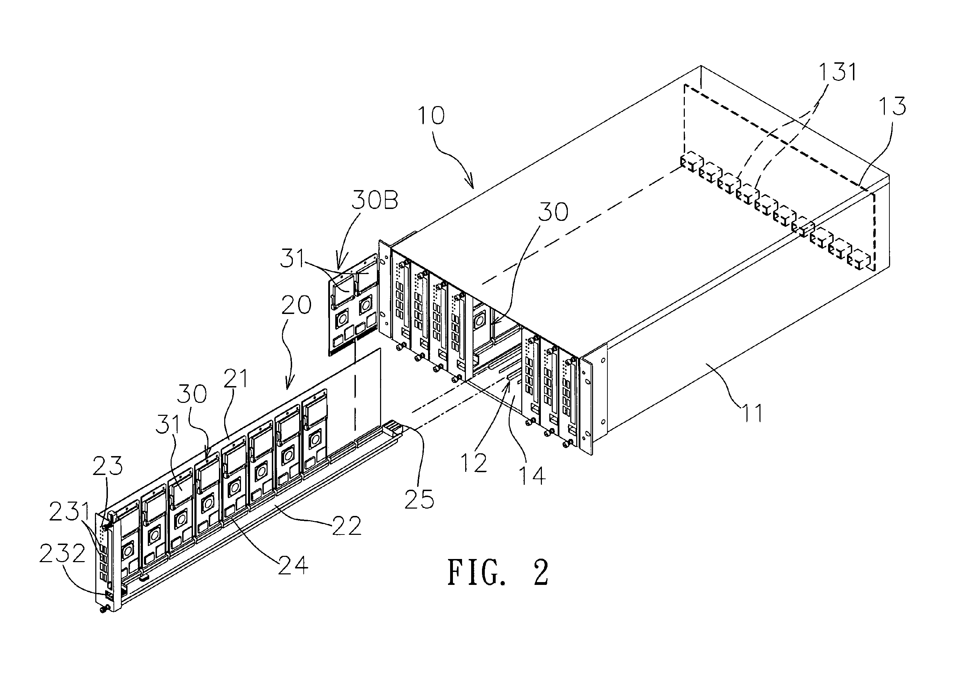

With reference to Figs. 1 and 2 for a high-density computer system with a high-performance CPU card sharing structure in accordance with a first preferred embodiment of the present invention, the high-density computer system comprises a chassis 10, at least one expansion card module 20 and a plurality of CPU cards 30. The chassis 10 includes a casing 11, and the casing 11 includes a bottom panel 14, and the bottom panel 14 includes a containing space 12 for installing a plurality of slide rails (or other components), and the chassis 10 further includes a main backplane 13 installed at the rear of the chassis 10, and the main backplane 13 includes a main control circuit installed thereon, and the main backplane 13 includes a plurality of main backplane slots 131 opposite to the containing space 12, and the main control circuit and the main backplane slots 131 are used for transmitting data signals through a primary I/O bus (not shown in the figure) installed on the main backplane 13.

The expansion card module 20 is inserted and installed into the containing space 12 of the casing 11, and the expansion card module 20 includes a sub-backplane 21, and the sub-backplane 21 includes a sub-control circuit and a plurality of second sub-backplane slots 24 thereon, and the sub-backplane 21 is fixed into a position by a lower panel 22 and a front panel 23, and the rear end of the sub-backplane 21 has a first sub-backplane slot 25, such that when the expansion card module 20 is inserted into the containing space 12, the first sub-backplane slot 25 is aligned and positioned opposite to the corresponding main backplane slot 131, such that the sub-backplane 21 and the main backplane 13 are electrically coupled. In other words, the sub-control circuit and the second sub-backplane slots 24 can be used for transmitting/receiving data signals through the first sub-backplane slot 25 and the main backplane 13. The front panel 23 includes a plurality of display windows 231 and electric slots 232 electrically coupled to the sub-control circuit. In another preferred embodiment, the sub-backplane 21 can be installed at the position of the lower panel 22 instead. In other words, the positions of the sub-backplane 21 and the lower panel 22 are switched.

The CPU card 30 is installed on the expansion card module 20, and the CPU card 30 includes a CPU 31, and an end of the CPU card 30 has a conductive terminal (such as a goldfinger) provided for inserting into the second sub-backplane slot 24 of the sub-backplane 21, such that the CPU card 30 and the sub-backplane 21 are electrically coupled. The CPU card 30 can be an independent computing system, or a plurality of CPU cards 30 allocated for executing an integrated computing system.

The high-performance CPU card 30B (or 30C or 30D) has two or more CPUs 31, and each high-performance CPU card 30B, 30C, 30D is inserted and connected to two or more positions of the second sub-backplane slots 24 respectively.

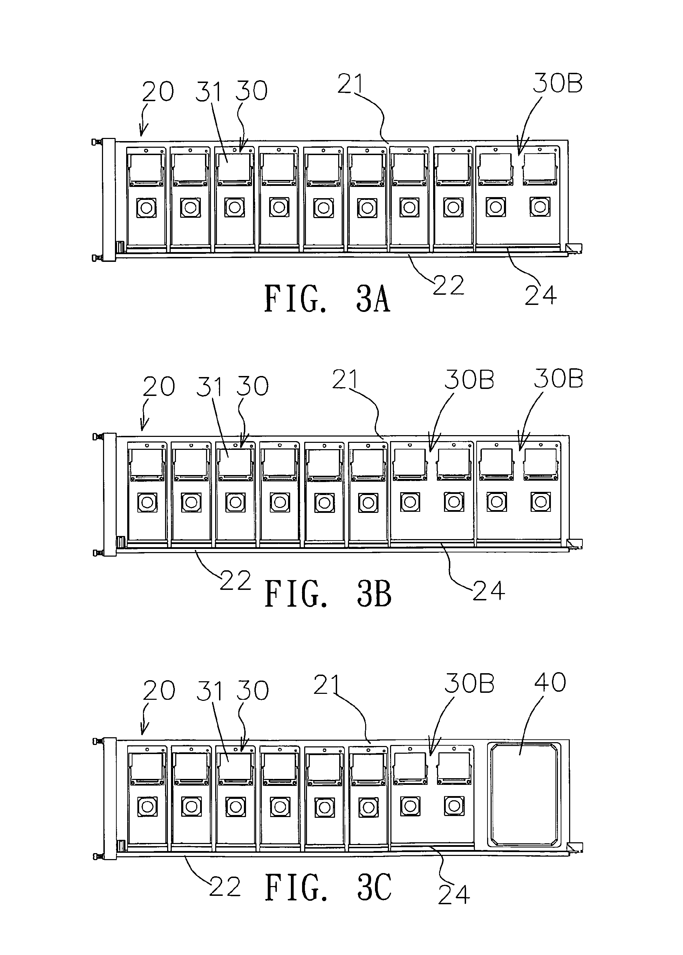

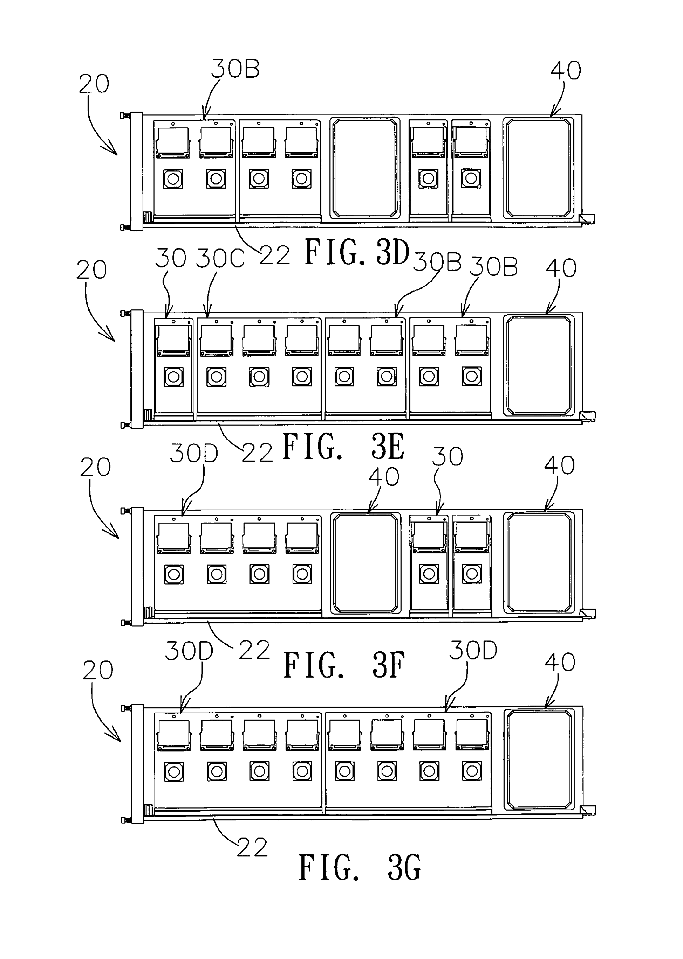

With reference to FIGS. 3A to 3G for a high-density computer system with a high-performance CPU card sharing structure in accordance with the present invention, the computer system has powerful modular assembling function, swappability and replaceability to provide advantages on manufacturing, assembling and flexible expansion applications, so as to enhance the economic benefits and product competitiveness. For example, the expansion card module 20 includes 10 second sub-backplane slots 24 as shown in Fig. 3A, wherein the sub-backplane 21 includes eight CPU cards 30 and one high-performance CPU card 30B installed thereon, and the high-performance CPU card 30B is inserted and coupled to the positions of two second sub-backplane slots 24. In Fig. 3B, the sub-backplane 21 includes six CPU cards 30 and two high-performance CPU cards 30B installed on the sub-backplane 21, and the high-performance CPU cards 30B are inserted and coupled to positions of two of the second sub-backplane slots 24. In Fig. 3C, the sub-backplane 21 includes six CPU cards 30, one high-performance CPU card 30B and one data storage device 40 installed on the sub-backplane 21, and the high-performance CPU card 30B and the data storage device 40 are inserted and coupled to positions of two of the second sub-backplane slots 24. In Fig. 3D, the sub-backplane 21 includes two high-performance CPU cards 30B, one data storage device 40, two CPU cards 30 and one data storage device 40 sequentially installed on the sub-backplane 21, wherein the two data storage devices 40 are installed separately. In Fig. 3E, the sub-backplane 21 includes one CPU card 30, one high-performance CPU card 30C, two high-performance CPU cards 30B and one data storage device 40 sequentially installed on the sub-backplane 21. In Fig. 3F, the sub-backplane 21 includes one high-performance CPU card 3D, one data storage device 40, two CPU cards 30 and one data storage device 40 sequentially installed on the sub-backplane 21, wherein the two data storage devices 40 are installed separately. In Fig. 3G, the sub-backplane 21 includes two high-performance CPU cards 30D and one data storage device 40 sequentially installed on the sub-backplane 21. The aforementioned CPU cards 30B, 30C, 30D are high-performance CPU cards. In the same modular structure, the expansion card module 20 (or sub-backplane 21) can further include at least one wireless module, 3D image module, or related module of other computer and Internet applications to provide a flexible replacement, addition or allocation in a sharing architecture. In the foregoing preferred embodiment, the high-performance CPU cards 30B, 30C, 30D refer to the CPU cards having two, three and four CPUs installed at positions of two, three and four of the second sub-backplane slots 24 respectively, and such application can be changed according to actual requirements.

As described above, a high-density computer system with a high-performance CPU card sharing structure the of the present invention utilizes the plurality of second sub-backplane slots 24 of the sub-backplane 21 formed on each expansion card module 20, and further upgrades with a plurality of CPU cards 30 and at least one high-performance CPU card 30B (30C, 30D), such that the computer system can increase the number of installed CPUs 31 to achieve the real-time multitasking function, and achieve the effects of improving the computing functions and making an upgrade or adjustment quickly to meet the economic benefits in compliance with the user requirements. In the meantime, the modular design provides a flexible installation of the data storage device 40 and allow modular variations of the CPU card 30 (such as the high-performance CPU card 30B-30D), such that the invention provides powerful modular assembling function, swappability and replaceability to provide advantages on manufacturing, assembling and flexible expansion applications, so as to enhance the economic benefits and product competitiveness.

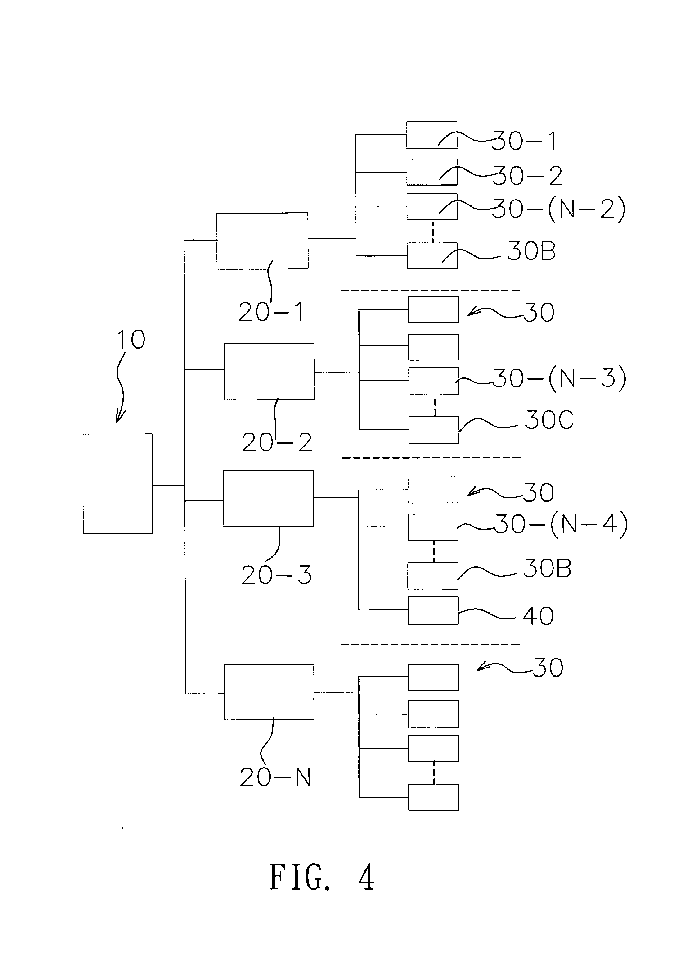

With reference to Fig. 4 for the system architecture of the present invention, the chassis 10 includes at least one expansion card module 20 (including 20-1, 20-2, ...20-N) installed in the chassis 10 to constitute a computer system, and each expansion card module 20 (including 20-1, 20-2, ...20-N) further includes a plurality of CPU cards 30 (including 30-1, 30-2, ...30- N-4, 30-N-2...) and at least one high-performance CPU card 30B (30C, 30D) to produce the high-density computer system with a high-performance CPU card sharing structure of the present invention and achieving the effect of increasing the number of installed CPUs 31 of the computer system to produce a high-density.

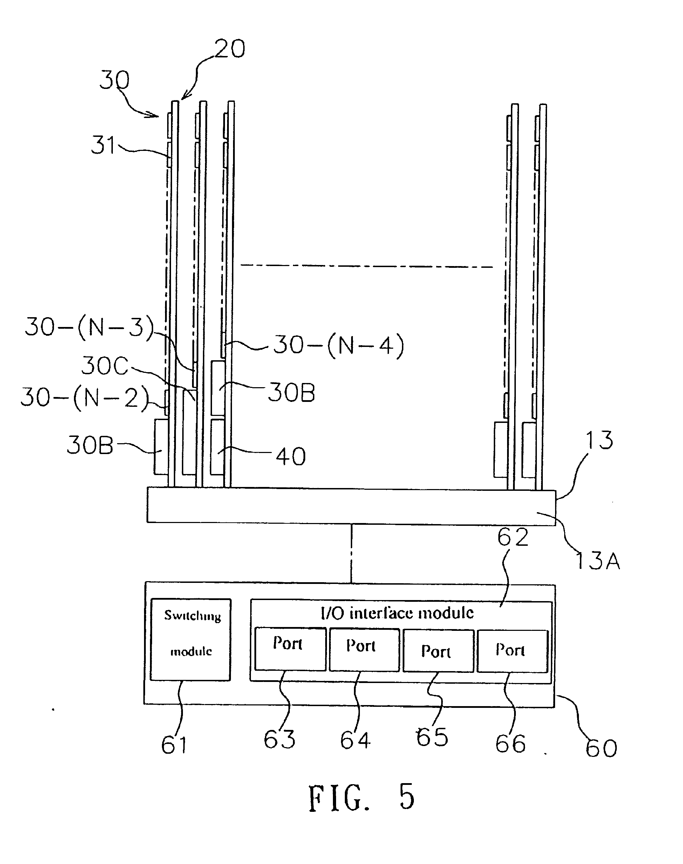

With reference to Fig. 5 for the high-density computer system with a high-performance CPU card sharing structure of the present invention, the main control circuit 13A of the main backplane 13 of the computer system includes a monitoring module 60 for selectively and electrically coupling the CPU card 30 (or CPU 31) to read information of the CPU 31, and the monitoring module 60 further includes a switching module 61 and an I/O interface module 62, and the switching module 61 is provided for selectively and electrically coupling the data storage device 40 to one of the CPU cards 30 or high-performance CPU card 30B (30C, 30D) to access data. For example, the switching module 61 can select one or more CPU cards 30 or high-performance CPU cards 30B (30C, 30D) as a server to read and write data. The I/O interface module 62 includes at least one port 63 for inserting and installing an external device to transmit control data to the port or receive control data from the port, and the I/O interface module 62 further includes a keyboard port 64, a video port 65 or a mouse port 66 for monitoring a switch such as the keyboard-video-mouse (KVM) switch.

With the aforementioned assembly, the application of the high-density computer system with a high-performance CPU card sharing structure in accordance with the present invention has the following advantages:
1. If it is necessary to add a function (such as a storage, wireless, encryption/decryption, 3D image and other computer and Internet applications and other related modules) at a client end or require a high-performance application, only the desired upgrading CPU card 30 (or CPU) which is the high-performance CPU card 30B (30C, 30D) is replaced, without the need of replacing all of them.
2. Different storage modules can be selected according to customer requirements, thus improving the expandability of the products.
3. The computer system can be shared.

In summation of the description above, the present invention complies with the patent application requirements, and is thus duly filed for patent application. While the invention has been described with reference to a preferred embodiment thereof, it is to be understood that modifications or variations may be easily made without departing from the spirit of this invention, which is defined in the appended claims.

## Claims

1. A high-density computer system with a high-performance CPU card sharing structure, comprising:
a chassis 10, having a plurality of containing spaces 12, a main backplane 13 installed in the chassis 10, and a main control circuit 13A and a plurality of main backplane slots 131 respectively installed and formed on the main backplane 13;
at least one expansion card module 20, inserted and installed in the containing space 12, and including a sub-backplane, a sub-control circuit and a plurality of second sub-backplane slots 24 respectively installed and formed on the sub-backplane, and a first sub-backplane slot 25 formed at an end of the sub-backplane 21 and corresponding to one of the main backplane slots 131;
at least one CPU card, installed on the expansion card module 20, and inserted into one of the second sub-backplane slots 24, and having a CPU 31;
at least one high-performance CPU card 30B, 30C, 30D, installed on the expansion card module 20, and having at least two CPUs 31, and inserted and coupled to positions of two or more of the second sub-backplane slots 24.

2. The high-density computer system with a high-performance CPU card sharing structure according to claim 1, wherein the CPU card 30, the CPU 31 or the high-performance CPU card 30B, 30C, 30D is an independent computing system.

3. The high-density computer system with a high-performance CPU card sharing structure according to claim 1, wherein the CPU cards 30, the CPUs 31 or the high-performance CPU cards 30B, 30C, 30D are allocated for executing an integrated computing system.

4. The high-density computer system with a high-performance CPU card sharing structure according to claim 1, wherein the sub-backplane 21 is installed and fixed by a bottom panel 14 and a front panel 23.

5. The high-density computer system with a high-performance CPU card sharing structure according to claim 1, further comprising a conductive terminal or a goldfinger formed at an end of the CPU card 30 or the high-performance CPU card 30B, 30C, 30D and electrically coupled to the second sub-backplane slot 24.

6. The high-density computer system with a high-performance CPU card sharing structure according to claim 1, wherein the expansion card module 20 further comprises at least one data storage device 40 electrically coupled to the second sub-backplane slot 24.

7. The high-density computer system with a high-performance CPU card sharing structure according to claim 6, wherein the data storage device 40 is inserted and coupled to positions of two second sub-backplane slots 24.

8. The high-density computer system with a high-performance CPU card sharing structure according to claim 7, further comprising a connector module coupled to an end of the data storage device 40, and the connector module having a first connector and a second connector disposed at both ends of the connector module respectively, and the first connector being coupled to the data storage device 40, and the second connector being installed into the second sub-backplane slot 24 to complete electrically coupling the data storage device 40 to the sub-backplane 21.

9. The high-density computer system with a high-performance CPU card sharing structure according to claim 1, further comprising a monitoring module 60 for selectively and electrically coupling the CPU card 30 to read information of the CPU 31.

10. The high-density computer system with a high-performance CPU card sharing structure according to claim 9, wherein the monitoring module 60 further comprises an I/O interface module 62, and the I/O interface module 62 including at least one port 63 for inserting and installing an external device and transmitting control data to the port 63 or receiving control data from the port 63.

11. The high-density computer system with a high-performance CPU card sharing structure according to claim 10, wherein the I/O interface module 62 includes a keyboard port 64, a video port 65 or a mouse port 66.

12. A high-density computer system with a high-performance CPU card sharing structure, comprising:
a chassis 10, having a plurality of containing spaces 12, a main backplane 13 installed in the chassis 10, and a main control circuit 13A and a plurality of main backplane slots 131 respectively installed and formed on the main backplane 13; at least one expansion card module 20, inserted and installed in the containing space 12, and including a sub-backplane 21, a sub-control circuit and a plurality of second sub-backplane slots 24 respectively installed and formed on the sub-backplane 21, and a first sub-backplane slot 25 formed at an end of the sub-backplane 21 and corresponding to one of the main backplane slots 131; and at least one high-performance CPU card 30B, 30C, 30D, installed on the expansion card module 20, and having at least two CPUs 31 installed on the high-performance CPU card 30B, 30C, 30D, and the high-performance CPU card 30B, 30C, 30D being inserted and coupled to positions of two or more of the second sub-backplane slots 24.

13. The high-density computer system with a high-performance CPU card sharing structure according to claim 12, wherein the expansion card module 20 includes at least one CPU card 30 installed thereon, and inserted into one of the second sub-backplane slots 24, and having a CPU.

14. The high-density computer system with a high-performance CPU card sharing structure according to claim 12, wherein the expansion card module 20 further includes at least one data storage device 40 inserted and coupled to two of the second sub-backplane slots 24.
